# EUROPEAN PATENT APPLICATION

(11) **EP 2 369 696 A1**
(43) Date of publication of application: **28.09.2011**
(21) Application number: 10003025.3
(22) Date of filing: 23.03.2010
(51) Int. Cl.: H01S 5/183, H01S 5/14, H01S 5/30

(54) **Surface-Emitting semiconductor laser and method of manufacture thereof**

(71) Applicant: ETH Zurich, 8092 Zürich (CH)
(72) Inventor: Felder, Ferdinand, 8006 Zürich (CH); Rahim, Mohamed, 8048 Zürich (CH); Fill, Matthias, 8048 Zürich (CH); Arnold, Martin, 5400 Baden (CH); Zogg, Hans, 8114 Dänikon (CH)

(57) **Abstract**

A VECSEL-type surface-emitting semiconductor laser device is manufactured by providing a first component part (10) comprising a layered first mirror (12), providing a second component part (20) comprising a layered active region (22), permanently joining the second component part to the first component part to form an integral unit, and arranging a second mirror (32) so as to form an optical cavity containing the active region. This method of manufacture enables production at lower cost and enables greater flexibility in the choice of materials for the mirrors and the active region as well as for the substrates on which the first mirror and the active region are deposited, as compared to traditional monolithic epitaxy methods. Preferably, the laser device is a IV-VI-type VECSEL emitting in the mid-IR range of the electromagnetic spectrum.

## Description

### TECHNICAL FIELD

The present invention relates to a surface-emitting semiconductor laser device comprising a first mirror having at least one mirror layer, and a second mirror forming an optical cavity with the first mirror. An active region (gain medium) having at least one active layer made of a semiconductor material is located inside the optical cavity. In particular, the present invention relates to a so-called vertical external cavity surface-emitting laser (VECSEL), in particular a VECSEL having a design frequency in the mid-infrared (mid-IR) region of the electromagnetic spectrum, and more particularly a VECSEL having an active region based on lead chalcogenides or related IV-VI narrow-gap semiconductors. The present invention further relates to a method of manufacture for such a laser.

### PRIOR ART

Mid-infrared semiconductor lasers have been known since the 1970s. Typically, they are electrically pumped edge emitters which are cryogenically cooled in operation. The typical spectral range of operation ranges from about 2 to 20 micrometer wavelength. This range will in the following be called the "mid-IR range". Such lasers are typically realized with "narrow-gap" semiconductors, i.e., semiconductors having a bandgap below approximately 0.2 eV. One main application of mid-IR semiconductor lasers is spectroscopy. However, if sufficiently high power is available, such lasers may be used also for other applications, e.g. for medical surgery, material processing, free space data communication and also for military countermeasures.

As laser materials, IV-VI narrow-gap semiconductors like PbSnTe, PbSrTe, PbEuTe (Te may also be fully or partly replaced by Se or S) in various compositional ranges proved to be suited. Such lasers are typically electrically pumped and cooled to cryogenic temperatures.

More recently, also III-V semiconductors (e.g., GaAs, InP, GaSb or InSb based) have been used to cover the mid-IR range, with at least two approaches: (a) Type-W edge emitting lasers and (b) quantum cascade lasers (QCL). Both types use sophisticated structures including quantum wells. By the way of example, QCLs are unipolar devices with up to several hundred monolithically grown thin layers as cascades. They contain up to more than 1000 interfaces. Their fabrication is complicated and expensive.

Recent examples of both types (a) and (b) may operate even at room temperature and with high (Watt-level) power. However, both types have a strongly asymmetric astigmatic beam with a very high divergence angle in one direction (e.g. 60°). Their beam quality is bad. Elaborate optical set-ups have to be used to obtain a useful output beam suited, e.g., for spectroscopic applications. By the way of example, a set-up for a QCL, having an elaborately designed collimation system, is described in US 7,466,734.

Much is gained if the laser emits a circular beam vertical to the surface. Such devices are called vertical cavity surface emitting lasers (VCSEL) or sometimes semiconductor disc lasers. They exhibit a very good beam quality. They may be realized with monolithic III-V type semiconductor layers and may operate up to about 2.8 micrometer wavelengths. They are generally grown as a monolithic structure on, e.g., a GaAs substrate, the layer sequence forming first a Bragg mirror, then an active region (gain medium) in the form of one or more active layers, followed by a second Bragg mirror. Their output power is typically in the mW range. Monolithic IV-VI narrow-gap semiconductor-based mid-IR VCSELs have also been described. Emission wavelength is up to >6 micrometer, they are typically cooled, but may operate up to above room temperature in pulsed operation. An example is given in T. Schwarzl, G. Springholz, M. Böberl, E. Kaufmann, J. Roither, W. Heiss, J. Fürst, and H. Pascher, "Emission properties of 6.7 µm continuous-wave PbSe-based vertical-emitting microcavity lasers operating up to 100 K", Appl. Phys. Lett. 86, 031102 (2005).

Much higher output power may be obtained with vertical *external* cavity surface emitting lasers (VECSELs). A VECSEL typically has cylindrical symmetry. It typically comprises a substrate, on which a first (bottom) mirror in the form of a monolithically grown Bragg mirror is disposed. An active region, generally in the form of an active layer stack, is disposed on the Bragg mirror. The active layer stack may optionally contain quantum wells. The thickness of this part is generally a few micrometers only, and the active layers are typically grown by molecular beam epitaxy (MBE) or related epitaxial growth techniques directly onto the bottom Bragg mirror. The laser cavity is completed by an external second mirror, which is spaced from the active layer stack and which may or may not be curved. The first or second mirror may serve as an output coupler. The space between the active layer stack and the second mirror may be used for coupling an exciting beam to the active layer stack for optical excitation, and/or for arranging other elements like a gas cell for intracavity gas spectroscopy or a frequency doubler (if the laser operates in the near-IR range). If a curved mirror is used, the modes are determined by the length of the cavity and the curvature radius of the curved mirror and can be well defined, leading to easy scalability. Optical pumping is preferably used for high power devices, but electric pumping may also be used. More elaborate set-ups are often employed with additional folding mirrors, to obtain still higher output powers.

VECSELs emitting up to 2.8 micrometer wavelength have been realized with GaSb-based techniques, i.e., III-V type semiconductors, as reviewed, e.g., in N. Schulz, J.-M. Hopkins, M. Rattunde, D. Burns, J. Wagner, "High-brightness long-wavelength semiconductor disk lasers", Laser & Photonics Review 2, 160 (2008). VECSELs emitting above 3 micrometer wavelength have also been demonstrated, using IV-VI type narrow-gap material, as disclosed in M. Rahim, M. Fill, F. Felder, D. Chappuis, M. Corda and H. Zogg, "Mid-infrared PbTe Vertical External Cavity Surface Emitting Laser on Si-substrate with above 1 W output power", Appl. Phys. Lett., 95, 241107, 2009.

### SUMMARY OF THE INVENTION

Presently employed manufacturing techniques for VECSELs limit the design possibilities for such lasers and are relatively expensive. It is an object of the present invention to provide a laser of the VECSEL type that can be manufactured more flexibly and more cost-efficiently than present VECSELs.

According to a first aspect of the present invention, a method for manufacturing a surface-emitting laser device is provided, the method comprising:
providing a pre-fabricated first component part comprising a first mirror having at least one mirror layer;
providing a pre-fabricated second component part comprising an active region having at least one active layer made from a semiconductor material;
joining the second component part to the first component part to form an integral unit;
providing a second mirror forming an optical cavity with the first mirror such that the active region is located inside said optical cavity, so as to obtain a surface emitting semiconductor laser device.

In other words, the present invention provides a method of manufacturing a VECSEL-type laser device, wherein the first mirror and the active region of the device are fabricated separately and permanently joined together only subsequently. In contrast, in the prior art, the active layer(s) are normally grown directly onto the first mirror (or vice versa) in the same growth run, since it is commonly thought that an exact lattice match between the different materials is required in order to get a sufficient interface quality without disturbing interface effects, which would disturb proper operation. Furthermore, it is commonly thought that these parts must be grown monolithically together to ensure a sufficiently high heat conductivity for efficient heat removal. The present invention overcomes this prejudice and shows that a comparable performance of the laser device as with monolithic growth methods can be achieved if these parts are manufactured separately and subsequently joined or bonded together.

The novel manufacturing method of the present invention offers distinct advantages over prior-art methods. In particular, much higher fabrication yield is obtained when two simper structures are grown separately rather than when one single more complicated structure is grown. Depending on the desired specifications (e.g. emission wavelength and/or output power) of the complete laser device, the pre-fabricated component parts may be combined at will to obtain the desired device, rather than growing a separate complete structure for each different specification. In particular, Bragg mirrors generally are quite broadband, i.e. exhibit the required very high reflectivity over a considerable spectral range. In contrast, the active region (gain medium) is generally optimal only in a very limited spectral window. In the method of the present invention, small pieces of Bragg mirrors fabricated in the same batch (grown on a large wafer) may be combined with gain media of different design. This considerably eases production. In addition, the present invention offers a larger choice of substrates than if all layers have to be grown on the same single substrate. In particular, the substrate of each component may be optimized for particular aspects like heat transfer, beam transmission etc., as further detailed below. In some embodiments, the first mirror (like the second mirror) need not be grown epitaxially. Any polycrystalline or amorphous material may be deposited as layers to form a high reflecting Bragg mirror. After batch fabrication, such low cost mirrors may be joined to the active region, resulting in a low-cost laser device. Use of polycrystalline or amorphous mirror layers is not possible for the bottom mirror of prior-art VECSEL devices.

The first and second component parts may be permanently joined or even bonded at the atomic level by a variety of different methods. In a particularly simple preferred method, the first and second component parts are simply pressed together, with or without subsequent annealing, and in the absence of any adhesives between the surfaces of the first and second component parts. The pressing may be carried out at or around room temperature, i.e., elevated temperatures are not required. Other possibilities include soldering or known methods of wafer bonding for establishing van-der-Waals or covalent interactions at the atomic level, including liquid capillary bonding, wafer bonding under increased pressure and temperature, or wafer fusion techniques. Such techniques are well known in the art. In particular, wafer bonding or wafer fusion techniques are summarized in V. Dragoi, "Wafer Bonding: Key Enabling Technology for Photonic Integration", IEEE Photonics Society Newsletters (December 2009), pp. 11-15. Liquid capillary bonding is described, e.g., in C.F. Jerez-Hanckes et al., "A Study of Si Wafer Bonding via Methanol Capillarity", Materials Physics and Chemistry 77 (2002), pp. 751-754. These documents are incorporated herein by reference in their entirety for teaching methods of joining separately fabricated structures, particular, layered semiconductor structures. The second mirror may also be joined to the second component part in this manner.

The first component part may comprise a first substrate, on a surface of which the first mirror is disposed. Likewise, the second component part may comprise a second substrate, on a surface of which the active region is disposed. The second component part may be joined to the first component part in different orientations, so as to result in different layer sequences. In some embodiments, the second component part is joined to the first component part in an orientation so that the active region faces the first component part and the second substrate faces away from the first component part. In particular, the active region may be placed immediately adjacent to the first mirror and joined with the first mirror. In such embodiments, the resulting topmost layer will be the second substrate. The second substrate may then be subsequently removed partially or completely, e.g., by well-known liftoff techniques. In other embodiments, the second component part is joined to the first component part in an orientation so that the second substrate faces the first component part, in particular, the first mirror, and the active region faces away from the first component part.

The first mirror need not be deposited directly on the first substrate, but may have been epitaxially grown or otherwise deposited on some auxiliary substrate and subsequently transferred to the first substrate, e.g., by epitaxial liftoff techniques. In other words, the step of providing the first component part in the method of manufacture may comprise:
depositing the at least one mirror layer on a first auxiliary substrate;
removing the at least one mirror layer from said first auxiliary substrate; and
joining the at least one mirror layer to said first substrate.

The same is true for the active region. In other words, the step of providing the second component part may comprise:
depositing, in particular, epitaxially growing the at least one active layer on a second auxiliary substrate;
removing the at least one active layer from said second auxiliary substrate; and
joining the at least one active layer to said second substrate.

Depending on the output power needed, different substrates may be used. For highest output powers, substrates with highest thermal conductivity like diamond or SiC may be used as the first or second substrate. If a diamond substrate is arranged inside the cavity, one has to consider the slight 2-phonon absorption of diamond in the 1600 - 2600 cm⁻¹ wavelength range. This absorption may inhibit lasing, but may be tolerable if thin enough diamond substrates are used. If a SiC substrate is arranged inside the cavity, some spectral range restrictions apply as well, as they will be readily known to a person skilled in the art.

According to a second aspect of the present invention, a laser device is provided that is obtainable by a method of manufacture as described above. In particular, a laser device is provided comprising:
a first component part comprising a first mirror having at least one mirror layer, preferably a plurality of mirror layers;
a second component part comprising an active region having at least one active layer, preferably a plurality of active layers, made of a semiconductor material, the second component part being pre-fabricated and joined to said first component; and
a second mirror forming an optical cavity with the first mirror such that the active region is located inside said optical cavity.

Such a laser device necessarily has an interface between the first component part and the second component part that is differently structured than in traditional devices grown monolithically, since these two parts have been joined together after separate manufacture of each part instead of having been grown epitaxially one onto the other as in the prior art. The different structure can readily be recognized by visual inspection and/or microscopic techniques (in particular, in cross sectional images taken by optical or electron microscopy).

Preferably, the laser device is a VECSEL device, in particular, a VECSEL emitting in the mid-IR region (2 to 20 micrometers). The at least one active layer is preferably epitaxially grown. The active region preferably comprises at least one active layer of epitaxially grown IV-VI semiconductor material, in particular, a lead chalcogenide material, preferably a material of composition Pb₁₋ₓXₓTe_{1-y-w}Ee_{y}S_{w}, wherein X is selected from the group consisting of Sn, Sr, Eu, wherein 0≤x≤1, wherein 0≤y≤1, and wherein 0≤w≤1. However, the invention is not limited to specific materials, such as IV-VI materials, and is likewise applicable to III-V semiconductor materials.

In some embodiments, the active region may comprise several active layers (an active layer stack). The active region may comprise a plurality of quantum wells having a lower bandgap than adjacent regions of the active region. The quantum wells will generally be placed at the regions of the highest electrical field intensities of the standing wave in the cavity.

A plurality of materials may be chosen as substrates on which epitaxial growth is performed. In particular, each of the substrates mentioned above may consist of a monocrystalline material selected from the group consisting of silicon, diamond, silicon carbide, and group-IIa (alkaline earth metal) fluorides, in particular, barium fluoride.

At least one of the first mirror and second mirror will generally be a Bragg mirror (distributed Bragg reflector, DBR) comprising a plurality of mirror layers having refractive indices that substantially alternate between adjacent mirror layers. Preferably, these layers have an optical thickness of approximately one quarter wavelength in each of said mirror layers at a predetermined design frequency. The optical thickness may however deviate from this value for various reasons as long as sufficient reflectivity at the design frequency is ensured, e.g., in order to optimize transparency for a pump beam if illumination is carried our through this mirror. As mentioned above, the mirrors need not be grown epitaxially, but may comprise at least one polycrystalline or amorphous mirror layer. In particular, the second mirror may consist of a single highly reflective layer, e.g., a gold layer.

The laser device will normally be optically pumped in high-power applications, but may also be electrically pumped. In particular, if the laser device is optically pumped, the laser device may comprise a pump laser adapted to provide a pump beam coupled into the optical cavity of the laser device for optically pumping the active region.

The laser device may comprise a device for changing a length of the optical cavity, in particular, a piezoelectric device coupled to at least one of the second mirror and the integral unit formed of the first and second component part in order to change the distance between the first and second mirror, so as to provide a possibility for tuning the laser device (changing the emission wavelength). Alternatively, the device for changing the cavity length may comprise a micromechanical device, in particular, a micromechanical device made in Si technology. A range of a few micrometers for the length change is generally sufficient, and other devices that those described here are known to a person skilled in the art to achieve such adjustment.

Alternatively or in addition, the laser device may comprise a device for adjusting the operating temperature in order to tune the laser device, as they are as such well known in the art.

It is to be understood that all features associated with the above-described method according to the first aspect of the invention will find their correspondence in structural features of a resulting laser device manufactured according to this method, and that such features may be combined with any of the above-listed further features of a laser device according to the second aspect of the invention.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,
- Fig. 1: shows a schematic sketch of a first embodiment of a VECSEL according to the present invention;
- Fig. 2: shows a schematic sketch of a second embodiment of a VECSEL according to the present invention, the VECSEL having a short cavity length;
- Fig. 3: shows a schematic sketch of a third embodiment of VECSEL according to the present invention;
- Fig. 4: shows a schematic sketch of a further embodiment of a VECSEL according to the present invention, to illustrate the sequence of layers; and
- Fig. 5: shows a diagram containing three output spectra of a VECSEL in accordance with the setup of Fig. 4.

### DESCRIPTION OF PREFERRED EMBODIMENTS

For the purposes of the present invention, a VECSEL-type laser device may be broadly defined as follows: A VECSEL-type laser is a surface-emitting semiconductor laser having a flat or curved first ("bottom") mirror comprising at least one mirror layer, preferably a first Bragg mirror (distributed Bragg reflector, DBR). A second ("top") mirror, which may or may not be a Bragg mirror and which may be flat or curved, is disposed at a distance from the first mirror, forming an optical cavity with the first mirror. An active region (gain medium) comprising at least one active semiconductor layer is disposed in the cavity, the semiconductor layer being oriented such that the resulting laser beam in the cavity will be substantially perpendicular to the layer plane. The active region may optionally comprise quantum wells. Either the first or the second mirror is spaced from the active region. The space between the active region and the respective mirror may be filled with air and/or with at least one other material, e.g., with a substrate material, with a gas cell or, in particular if the design frequency is in the near-IR range, with a frequency-doubler. The first and/or the second mirror serves an output coupler for an output beam, whose wavelength may be identical to or (in the case of frequency-doubling) different from the design frequency. The laser may be optically or electrically pumped.

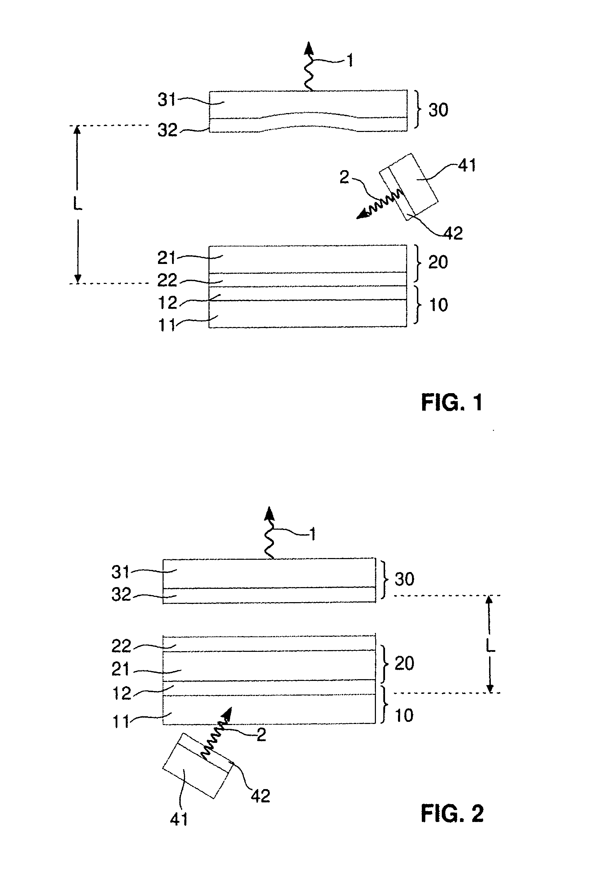

A first embodiment of a VECSEL according to the present invention is schematically illustrated in Fig. 1. It is to be noted that the dimensions are not to scale. In particular, the thickness of the individual parts of the laser along the vertical direction is strongly exaggerated in relation to the dimensions in the horizontal plane, in order to illustrate the sequence of layers in the laser device.

The VECSEL of Fig. 1 has cylindrical symmetry. In comprises a first substrate 11, which may, e.g., be a Si or BaF₂ substrate, on which a first (bottom) Bragg mirror 12 consisting of a plurality of alternating epitaxial layers of one quarter optical thickness at the design frequency (the frequency corresponding to the desired free-space wavelength, e.g. 5 micrometers) with alternating low and high refractive index has been grown. To this end, IV-VI narrow gap materials like Pb₁₋ₓXₓY (X= Sn, Sr, Eu etc., Y=Te, Se, S or mixtures thereof, 0≤x≤1 ) may be used for the high index materials. For the low index material, XY, Pb₁₋ₓXₓY with appropriate x so as to lead to a higher bandgap, or BaF₂ may be used.

However, any other materials which are transparent at the desired wavelengths may be used, too. The first substrate 11 and the first mirror 12 together form a first pre-fabricated component part 10.

On a second substrate 21, which may e.g. be a silicon substrate, an active region 22 is disposed, which has been grown by epitaxy. The active region may, e.g., consist of a single active semiconductor layer, e.g., an epitaxial Pb₁₋ₓXₓY layer of high structural crystalline quality. The thickness of this layer may be a multiple of a half wavelength at the design frequency if resonance conditions are desired. The layer may be followed by an antireflective coating. Instead of a single active layer, it is possible to use a plurality of semiconductor layers (a layer stack). In preferred embodiments, the active region contains quantum wells at the position of the highest electric field intensities of the standing waves in the cavity (in particular, at a distance of multiples of one half wavelength in the active region at the design frequency). This considerably lowers threshold power where lasing starts. The second substrate 21, the active region 22 and any optional further layers such as anti-reflective coatings together form a second pre-fabricated component part 20.

The second component part 20 is joined to the first component part 10 by orienting the second component part in parallel to the first component part 10 such that the active region 22 faces the first mirror 12, and pressing the first and second component parts together. The pressing may be carried out, e.g., by using a fixture with screws and a piston, with applied forces in the range of up to a few thousand Newtons, resulting in an estimated pressure up to approximately 10⁹ N/m². Alternatively, wafer bonding techniques as described above may be used to join the second component part 20 to the first component part 10.

A second (top) external mirror 32 is disposed at a distance from the second component part 20. In the present example, the second mirror 32 is an epitaxial Bragg mirror grown on a curved third substrate 31, which is transparent to the laser beam at the design frequency, e.g., a silicon substrate. Therefore the second mirror 32 is itself curved; however, this mirror may also be flat. The second mirror 32 may comprise similar material compositions as the first mirror 12. Alternatively, polycrystalline or amorphous layers may be used for these mirrors. In the present example, mirror 32 serves as an output coupler for an output beam 1. However, if the second mirror 32 is not used as output coupler, even highly reflective nontransparent materials (like Au, Al) may be used, and the substrate may be non-transparent for the laser beam. The third substrate 31 and the second mirror 32 together form a third component part 30.

The first (bottom) mirror 12 may be curved, too, and the same may apply to the active region 22. To this end, these elements may be grown on curved substrates as well.

The external first substrate 11 may be soldered to an appropriate heat-sink. The solder and/or heat sink may be made of appropriate metals (like In, Sn for the solder and Cu for the heat sink) if not used for beam transmission. If used as output or pump-beam coupler, the heat-sink and solder should be transparent to the beam, or a hole should be left open where the output or pump beam passes.

A pump laser 41 serves to optically pump the active region by a pump beam 2. Commercial diode lasers or fiber optic lasers may be used which emit in the 1-2 micrometer wavelength range, e.g. commercial edge emitting III-V semiconductor lasers. The pump laser may be followed by a lens 42 or collimating fiber optics. The pump beam 2 may illuminate from the same side as the output mid-IR beam, the axis of the pump beam inclined with respect to the axis of the VECSEL, as shown in Fig. 1. It may also illuminate through the first or second mirror if this mirror is transparent, on-axis with the output beam 1 or inclined to the output beam 1. All variations for pump/output beam directions are possible depending on the exact lay-out: top/top, top/bottom, bottom/top, bottom/bottom. In other embodiments, the VECSEL may be electrically pumped.

In the present example, the active region 22 faces the first mirror 12 when the first and second component parts 10, 20 are joined. However, the sequence of substrates, mirror and active region may also be different, e.g., the second substrate 21 may face the first mirror 12 when the first and second component parts 10, 20 are joined, so that the first mirror 12 and the second substrate 21 are joined. Alternatively, if, as in the present example, the second substrate 21 is the topmost layer, this substrate may be removed after joining by known techniques, e.g., by removing an interfacial layer between the active medium and the second substrate and lifting off the substrate, in order to increase beam transmission and to gain space in the optical cavity.

Before joining the first and second component parts 10, 20, the active layer(s) of the active region, which are a few micrometers thin, and/or the mirror layers may be removed from the substrates onto which they were originally grown and transferred to another better suited substrate. This e.g. may be diamond because of its extremely high heat conductivity, SiC or other materials which are less suited as substrates for epitaxial growth. This may be done with the well known "epitaxial lift-off" technologies and subsequent bonding, e.g. liquid capillary bonding.

One or several of the substrates may not have parallel bottom and top surface, but may be shaped to form a wedge. This avoids unwanted optical interferences between different reflected beam parts. A typical deviation-from-parallelism (wedge) angle may be in the range of 0.5-5°, e.g. approximately 2°.

For long cavity lengths L, a multitude of longitudinal modes may be excited. To select one specific mode, beam collimators, etalons, or external gratings may be employed, as known in the art. On the other hand, if the cavity length L is short, e.g., 5-30 micrometers, it is possible to excite only one single longitudinal mode since resonance conditions in the cavity do not allow other modes. Transversal modes are suppressed by collimating the pump beam to a small area only.

A second embodiment of a VECSEL according to the present invention is shown in Fig. 2, the VECSEL of this embodiment having a very short cavity length L in the range of less than 30 micrometers, with a correspondingly very short or even no air gap. Like parts carry the same reference numerals as in Fig. 1. The layer sequence is different from the sequence of Fig. 1, in that the second substrate 21 rather than the active region 22 is joined to the first mirror 12. Both the first and the second mirror are plane mirrors in this embodiment to simplify fabrication. Excitation is done by so called "end pumping", i.e. the laser pump beam 2 is fed into the optical cavity through the first substrate I 1 and the first mirror 12. In the present example, the pump beam direction is inclined relative to the cylinder axis of the VECSEL, but the pump beam may also run along the axis of the VECSEL. Substrate 11 and mirror 12 therefore have to be transparent at least at the pump wavelength. The mirror materials described above are transparent for typical pump beams (typical wavelengths 0.9 to 2.2 micrometers). As in the first embodiment, the pump beam 2 may be imaged onto the active region 22 by a lens 42 or another appropriate collimating system. More easily and at lower cost, the pump laser 41 may be just placed very near to the active region 22 at a distance where the lateral extensions of the astigmatic beam along the fast and along the slow axis are approximately equal, i.e. a near circular beam results. Alternatively, a fiber coupled pump laser may be used.

The layout of Fig. 2, due to the short cavity length, permits continuous mode-hop free tuning over a considerable wavelength range where the active semiconductor material shows gain. With the short cavity, only one or a few longitudinal modes develop over the spectral gain region of the active region. By changing the cavity length, it is therefore possible to tune the wavelength over a considerable range, which may be of the order above 10%. This requires a vertical displacement of the second mirror 32 by a few micrometers. Displacement can be achieved by piezomaterials and activation of the mirror mounts, or employing micro opto-electro mechanical system (MOEMS) technologies, as they are known in the art Alternatively, temperature tuning may be employed because the refractive index of the semiconductor materials changes appropriately with temperature.

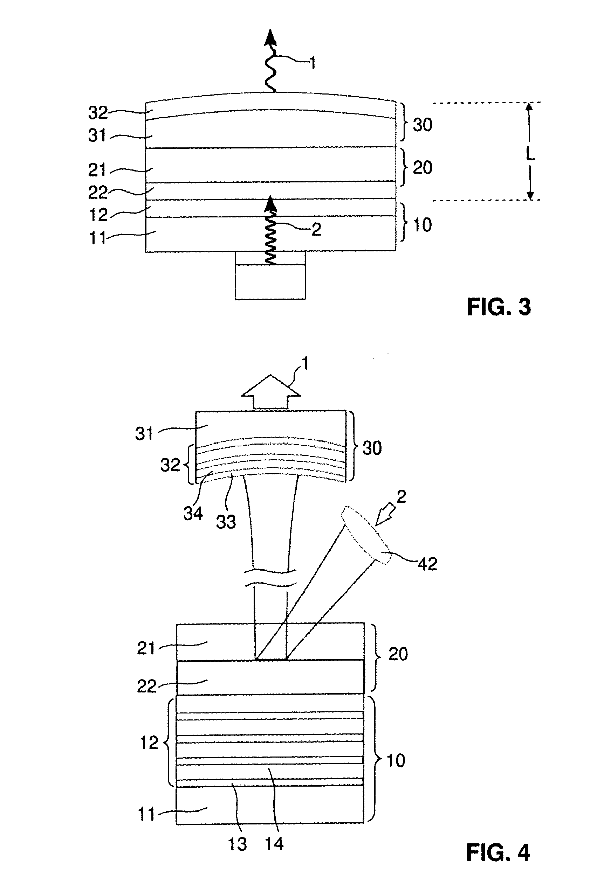

A third embodiment of a VECSEL according to the present invention is shown in Fig. 3. There is no need to have a free space (air gap) between the second component part 20 and the third component part 30, and these components may be joined. Fig. 3 shows a possible corresponding lay-out. Here, the second mirror 22 is disposed on an "extended" substrate 31 which touches the substrate 21 of the second component part 20. This "extended" substrate 31 may e.g. be silicon or any other transparent material including the IV-VI compositions described above, may be covered with a metal mirror layer, or contain a layer stack forming a Bragg mirror. The device may still be considered a VECSEL rather than a VCSEL due to the presence of the "extended" substrate 31, which is much thicker than the layers typically present in a prior-art VCSEL devices. This device may be tuned by temperature tuning. Spectral tuning ranges of several percent are accessible with thermoelectric cooling from room temperature to, e.g., -70°C.

The layouts in Figs. 1-3 are just examples. Substrates and mirror layers may be interchanged in all embodiments, i.e. the layers may be present on the opposite parts of the corresponding substrates. Therefore, in the final arrangement of the individual parts, a layer grown on a substrate may be followed by a layer, or by a substrate, or two substrates may touch each other. Either of the two mirrors may be flat (planar) or curved in any of these embodiments.

These layout may be made very compact: A typical cavity length of the first embodiment may be only a few millimeters, while the spot diameter of the mode on the active region is typically below about 0.3 mm. So a total size of below about 2 × 2 × 2 cm³ is possible. The second and third embodiments may be made still much more compact than the first embodiment. The compact size simplifies the task of finding a stable and rugged mechanical construction considerably.

An example of a concrete set-up realized in the laboratory is schematically illustrated in Fig. 4. Again, the drawing is not to scale. The same reference numbers as in Figs. 1-3 are used for like parts.

A first (bottom) mirror 12 in the form of a Bragg mirror was grown on a first Si substrate 11. The Bragg mirror consisted of four pairs of alternating layers 13, 14 of a high index material (Pb₀.₉₉Sr_{0.1}Te, refractive index n ≈ 5, thickness -200 nm) and a low index material (EuTe, n ≈ 2.4, thickness -500 nm). The layers were grown by MBE. The bottom mirror exhibited a reflectivity of R > 99.7% at the design frequency (corresponding to a free-space wavelength of 5 micrometers).

An active region 22 in the form of a single active layer with a thickness of one optical wavelength (1040 nm) consisting of PbSe was grown on a separate second Si substrate 21 by molecular beam epitaxy (MBE). The second component part 20 consisting of the second substrate 21 and the active region 22 was joined to the first component part 10 consisting of the first substrate 10 and the first (bottom) mirror 12 by pressing, the active region 22 facing the first mirror 21.

A separate curved second (top) mirror 32 with a radius of curvature of 50 mm was grown on a separate third substrate 31 in the form of a polished BaF₂ single crystal. The second mirror 32 was a Bragg mirror grown by MBE. It consisted of 2½ pairs of alternating layers 33, 34 of a high index material (Pb_{0.94}Eu_{0.06}Te, refractive index n ≈ 5, thickness -200 nm) and a low index material (BaF₂, n ≈ 1.4, thickness -900 nm). The second mirror 32 exhibited a reflectance of R > 99% at the design frequency. It was positioned at a distance of approximately 20 millimeters from the second substrate 21.

A pump beam 2 at a wavelength of 1.55 micrometers was coupled to the active layer through the second substrate 22 by means of a collimating lens 42.

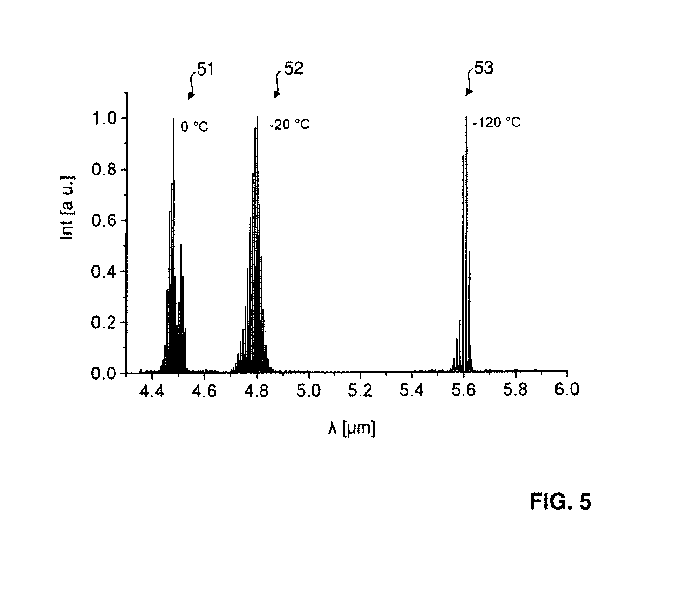

Lasing spectra were obtained at 10 kHz pulsed operation with 100 ns pulses and recorded with a Fourier infrared spectrometer. Fig. 5 shows examples of such spectra 51, 52, 53 recorded at temperatures of 0 °C, -20 °C and -120 °C, respectively. The spectra were multimode. The mode spacings are given by the optical thickness of the -400 µm thick second Si substrate 21 inside the cavity onto which the active layer was grown. The lasing wavelengths depended on temperature due to the temperature dependence of the band gap of the PbSe active layer. Peak power was approximately 0.4 W.

The tunable VECSEL devices of the present invention may be applied in a whole range of different applications. One such application is, e.g., trace gas spectroscopy for environmental monitoring. Other applications include trace gas, gas or liquid spectroscopy for industrial process control or medical analysis. Combustion gases and hydrocarbons have very strong absorption lines in the mid-infrared from 3 µm to 10 µm wavelength. Gas spectroscopy sensors therefore offer a very high sensitivity when operating within this wavelength region. By making the whole mid-infrared accessible, the mid-IR laser modules allow to harvest the full potential of spectroscopic sensors.

Other applications include medical surgery (tissue cutting or healing), material processing, or military countermeasures. There are two transparency windows in the mid-infrared 3-5 µm and 8-14 µm), where atmospheric absorption is minimal. This allows reliable signal transmission over long distances, i.e. free space communications.

### LIST OF REFERENCE SIGNS

- 1: output beam
- 2: pump beam
- 10: first component part
- 11: first substrate
- 12: first mirror
- 13, 14: mirror layers
- 20: second component part
- 21: second substrate

- 22: active region
- 30: third component part
- 31: third substrate
- 32: second mirror
- 33, 34: mirror layers
- 41: pump laser
- 42: lens
- 51, 52, 53: spectra

## Claims

1. A method of manufacturing a surface-emitting semiconductor laser device, comprising:
providing a pre-fabricated first component part (10) comprising a first mirror (12) having at least one mirror layer;
providing a pre-fabricated second component part (20) comprising an active region (22) having at least one active layer made from a semiconductor material;
joining the second component part (20) to the first component part (20) to form an integral unit;
providing a second mirror (32) forming an optical cavity with the first mirror (12) such that the active region (22) is located inside said optical cavity, so as to obtain a surface-emitting semiconductor laser device.

2. The method of claim 1, wherein the second component part (20) is joined to the first component part (10) by pressing or by a wafer bonding method, in particular, by liquid capillary bonding.

3. The method of claim 1 or 2, wherein the second component part (20) comprises a second substrate (21) on which the active region (22) is disposed, and wherein the second component part (20) is joined to the first component part (10) in an orientation so that the active region (22) faces the first component part (10) and the second substrate (21) faces away from the first component part (10).

4. The method of claim 3, further comprising at least partially removing the second substrate (21) after joining the second component part (20) to the first component part (10).

5. The method of claim 1 or 2, wherein the second component part (20) comprises a second substrate (21) on which the active region (22) is disposed, and wherein the second component part (20) is joined to the first component part (10) in an orientation so that the second substrate (21) faces the first component part (10) and the active region (22) faces away from the first component part (10).

6. The method of any of the preceding claims, wherein the step of providing the first component part (10) comprises:
depositing the at least one mirror layer (12) on a first auxiliary substrate;
removing the at least one mirror layer (12) from said first auxiliary substrate; and
bonding the at least one mirror layer (12) to a first substrate (11) to form the first component part (10).

7. The method of any of the preceding claims, wherein the step of providing the second component part (20) comprises:
depositing the at least one active layer on a second auxiliary substrate;
removing the at least one active layer from said second auxiliary substrate; and
bonding the at least one active layer to said second substrate (21) to form the second component part (20).

8. A surface-emitting semiconductor laser device, comprising:
a pre-fabricated first component part (10) comprising a first mirror (12) having at least one mirror layer;
a second component part (20) comprising an active region (22) having at least one active layer made of a semiconductor material, the second component part (20) being pre-fabricated separately and joined to said first component part (10) to form an integral unit; and
a second mirror (32) forming an optical cavity with the first mirror (12) such that the active region (22) is located inside said optical cavity.

9. The surface-emitting semiconductor laser device of claim 8, wherein the active region (22) comprises at least one active layer of epitaxially grown semiconductor material, in particular, a IV-VI semiconductor material.

10. The surface-emitting semiconductor laser device of claim 9, wherein the semiconductor material is a material of composition Pb₁₋ₓXₓTe_{1-y-w}Se_{y}S_{w}, wherein X is selected from the group consisting of Sn, Sr, Eu, wherein 0≤x≤1, wherein 0≤y≤1, and wherein 0≤w≤1.

11. The surface-emitting semiconductor laser device of any of claims 8 to 10, wherein the active region (22) comprises a plurality of quantum wells having a lower bandgap than adjacent regions of the active region (22).

12. The surface-emitting semiconductor laser device of any of claims 8-11, wherein the first component part (10) comprises a first substrate (11) on which said first mirror (12) is disposed and/or wherein the second component part comprises a second substrate (21) on which said active region (22) is disposed, and wherein at least one of the first substrate (11) and second substrate (21) consists of a monocrystalline material selected from the group consisting of silicon, diamond, silicon carbide, and group-IIa fluorides.

13. The surface-emitting semiconductor laser device of any of claims 8-12, wherein at least one of the first mirror (12) and second mirror (32) is a Bragg mirror comprising a plurality of mirror layers having refractive indices that substantially alternate between adjacent mirror layers.

14. The surface-emitting semiconductor laser device of any of claims 8-13, wherein at least one of the first mirror (12) and second mirror (32) comprises at least one polycrystalline or amorphous mirror layer.

15. The surface-emitting semiconductor laser device of any of claims 8-14, further comprising a pump laser (41) adapted to provide a pump beam (2) coupled into the optical cavity of the surface-emitting semiconductor laser device for optically pumping the active region (22).
